# EUROPEAN PATENT SPECIFICATION

(11) **EP 0 646 682 B1**
(45) Date of publication and mention of the grant of the patent: **26.07.2006**
(21) Application number: 94904014.1
(22) Date of filing: 11.01.1994
(51) Int. Cl.: E04D 3/40, E04D 13/18, H01L 31/042

(54) **ROOF INSTALLED WITH SOLAR BATTERIES**
MIT SONNENBATTERIEN AUSGESTATTETES DACH
TOIT EQUIPE DE PILES SOLAIRES

(30) Priority: 12.01.1993 JP 361793; 12.01.1993 JP 361893; 12.01.1993 JP 361993
(43) Date of publication of application: 05.04.1995
(73) Proprietor: MISAWA HOMES CO. LTD, Suginami-ku, Tokyo (JP)
(72) Inventor: ISHIKAWA, Osamu, Suginami-ku Tokyo 168 (JP); OYA,Naoko, Suginami-ku Tokyo 168 (JP)
(74) Representative: Haley, Stephen
(86) International application number: PCT/JP1994/000025
(87) International publication number: WO 1994/016170

(56) References cited:
- DE-A- 3 247 469
- DE-A- 3 314 637
- JP-B- 3 000 905
- JP-B- 4 023 701
- JP-U- 1 033 840
- US-A- 4 336 413
- US-A- 4 936 063
- PATENT ABSTRACTS OF JAPAN vol. 009, no. 031 (E-295), 9 February 1985 & JP 59 175168 A (FUJI DENKI SEIZO KK), 3 October 1984,
- PATENT ABSTRACTS OF JAPAN vol. 009, no. 031 (E-295), 9 February 1985 & JP 59 175169 A (FUJI DENKI SEIZO KK), 3 October 1984,
- PATENT ABSTRACTS OF JAPAN vol. 016, no. 440 (M-1310), 14 September 1992 & JP 04 153449 A (MISAWA HOMES CO LTD), 26 May 1992,
- PATENT ABSTRACTS OF JAPAN vol. 015, no. 509 (M-1195), 24 December 1991 & JP 03 224941 A (MISAWA HOMES CO LTD), 3 October 1991,

## Description

### BACKGROUND OF THE INVENTION

### 1. FIELD OF THE INVENTION

This invention relates to a roof with solar battery and is expected to be used as a roof of house. There are provided solar batteries in each roof to generate electric energy consumed in the house.

### 2. DESCRIPTION OF THE RELATED ART

There has been put solar batteries into practice to supply an electric power into an house as one building structure of which roof having the solar batteries to save consumption of energy.

The frame fixing method in which the panel solar battery unit is secured on the established roof with a dedication frame, when the solar batteries are installed on the roof, is generally known. It has also been known in the art that the so-called solar battery roofing tiles with built-in solar batteries on the roofing tile are arranged on the roof panel.

There are, however, the following defects for the frame fixing method.

First of all, a separate process is inevitable for frame anchoring, and roofing material of roofing tile, roofing board and common rafter are damaged, whereas it is difficult to obtain watertight type and durability.

In addition, an electrical wire of solar battery exposed into exterior is apt to be influenced by the immediate wind, rain and the sun light.

On the other hand, there are the following defects for the solar battery roofing tile.

An electric connector prepared at a joint part of the roofing tiles may be damaged by the rain-water.

As one of modem installation method to arrange solar batteries on the roof, a roofing technique, in which plural roof panels consisting of the roof panel defining a roof and plural solar battery modules in an associated state, has been developed.

The mentioned roof with solar battery provided with the solar battery module allows the installation of the solar battery at the same time of laying the roof and the avoidance of the exposure of the electric wiring and the leak of the rain-water and it gets rid of the defect in the mentioned conventional solar battery installation.

The solar battery module attached to each roof panel with solar battery is formed with many solar battery cells (solar battery elements) on the surface in a general rectangular thin panel state. Its dimensions is established for fitting into external dimensions of the roof panel on which solar battery modules are arranged along its length and width.

The voltage fitting to the number of the solar battery modules can be acquired from the roof panel with solar battery equipped with plural solar battery modules.

Namely, it is general that a solar battery module contains the designated output voltage according to the solar battery cell formed on the surface of the solar battery module and each solar battery module on the roof panel is connected in series.

These roof panels with solar battery are spread so as to form a roof for housing in an electrically connected state to one another to supply current (electric power).

Incidentally, in the above roof with solar batteries, there has been known following disadvantages.

First, when the solar battery itself is excessively heated, energy conversion efficiency tends to drop in.

The roof easily heat under shining sun light, also the solar battery in the roof can not avoid to be in high temperature condition, too.

Consequently, it was hard to improve the energy conversion efficiency for using.

The first purpose in this invention is to offer the roof with solar battery as securing a way to radiate heat and being able to improve energy conversion efficiency.

Second, in a case of using the above solar battery module, joints is naturally made between the plural solar battery modules. The solar battery modules are of structuring the roof, and are requested watertight property in the each joints.

However, in a general existing solar battery module, to be a complete dead water structure the weathering of the joints is a difficult subject.

The second purpose of this invention is to offer the roof with solar battery which can be improved dead water type between each solar battery modules.

Third, in using the roof paneled solar battery, number of the solar batteries on the roof panel is determined by dimensions of the roof panel, that is, output voltage in a sheet of the roof panel is restricted, whereat there is a trouble of inefficient electrical power supply.

Namely, the above power of electrical generation in the roof with solar battery is decided on a voltage provided by dimensions of the roof panel and on number of roof panel linked in parallel. Needed electrical power is not necessarily supplied always, and when electrical power is supplied more needed or less needed, possibility that state of the inefficient electrical power supply occurs can not be avoided.

The third purpose of this invention is to offer the roof with solar battery which can secure a only needed voltage in a sheet of the roof panel, and can supply efficient electrical power.

JP-A-59175168 discloses a roof with a solar panel with vent holes. DE-A-3314637 discloses a roof panel with a solar panel arranged to allow ventilation.

According to the present invention there is provided a roof with at least one solar battery (Y) the roof comprising:
a base panel extending along from the ridge portion (Q) to the eaves portion (P) of a tilted roof of a house;
at least one solar battery panel arranged along the upper surface of said base panel;
a frame receiving said at least one solar battery panel;
a supporting member supporting said frame on said base panel in use;
a ventilation layer provided between said solar battery panel and said base panel, the ventilation layer extending from the eaves portion to the ridge portion,
characterised by:
an upper eaves cutwater member provided at the eaves portion; and
a lower eaves cutwater member provided under the eaves portion which is substantially parallel to the upper eaves cutwater member;
wherein the space between the eaves cutwater members communicates with said ventilation layer in use and is provided with a ventilation louver.

### Brief Description of the Drawings

Fig. 1 is a schematically view of the first embodiment in accordance with the present invention;
Fig. 2 is a sectional view taken along the E-E line of Fig. 1 in the first embodiment;
Fig. 3 is a sectional view taken along the F-F line of Fig. 1 in the first embodiment;
Fig. 4 is an enlarged sectional view at "G" in Fig. 3 of the first embodiment;
Fig. 5 is a sectional view of an eaves portion in the first embodiment;
Fig. 6 is a sectional view of the second embodiment in accordance with the present invention;
Fig. 7 is a perspective view of the third embodiment in accordance with the present invention;
Fig. 8 is a sectional view of a connect portion of the third embodiment; and
Fig. 9 is a perspective view of a main portion of the third embodiment.

### Detailed Description of the Preferred Embodiment(s)

The explanation of embodiments of the present invention will be described with reference to the drawings.

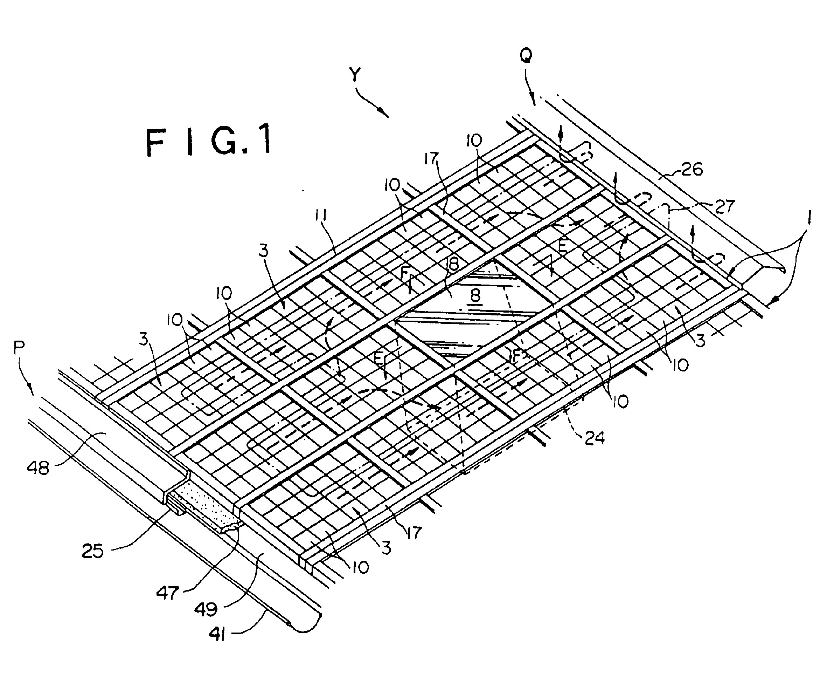

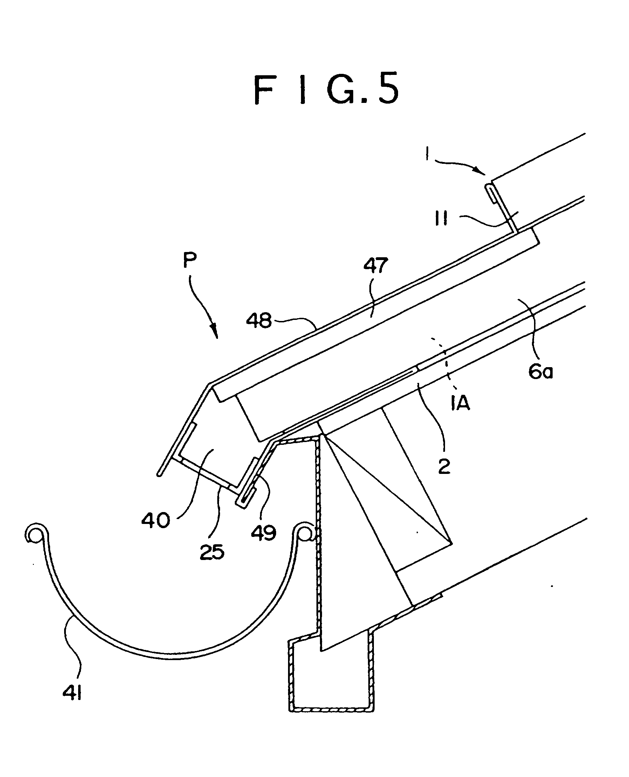

Figs. 1 and 5 depict examples of the first embodiment in accordance with the present invention.

Fig. 1 depicts a roof with solar battery Y of a general house with roof panel with solar batteries 1. The roof panel 1 can be utilized one or more upon necessity, however, of which number is optionally single, however, in the present invention, it should be plural so that the entire surface of the roof panel 1 is covered therewith.

The roof panel 1 is that plural flat solar battery modules (herein after referred to as module) 3 consisting of solar battery are attached on a rectangular base panel 2, as a base structure, along the roof tilted from an eaves P to a corresponding ridge Q.

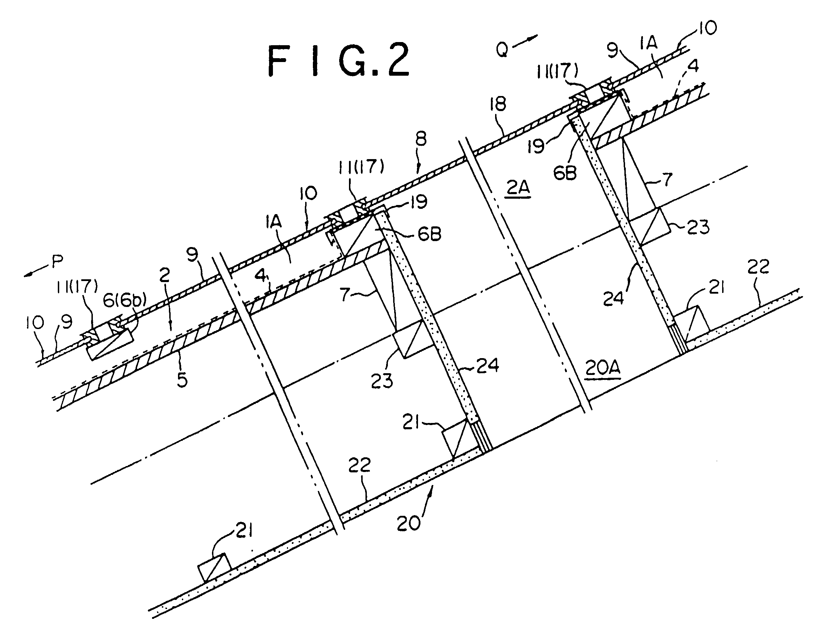

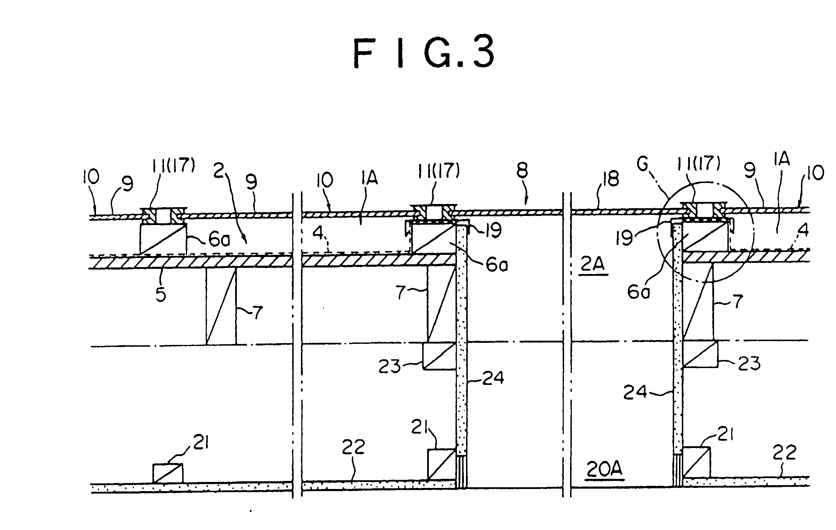

The base panel 2, as depicting in Figs. 2 and 3, is defined by a rectangular plywood 5 which has an asphalt roofing 4 spreaded thereon, plural cores 6 as supporting member at its upper side and common rafters 7 at its lower side. The cores 6 and common rafters 7 are secured on and under the plywood 5 by means of a bond agent and nails in a lattice pattern.

A core 6 is structured with longitudinal cores 6a extending in a longitudinal direction from one end to the other end of the base panel 2 and transverse cores 6b provided between the longitudinal cores 6a to perpendicularly intersect with the longitudinal cores 6a, the transverse cores 6b being made to have thinner thickness than and be secured on the longitudinal cores 6a so that both upper suffices are arranged to make a flat plane thereby, but in practice, only the longitudinal cores 6a are directly secured on such plywood 5 from which the transverse core 6b is away a little.

A solar battery module 3 is formed in a panel combined with plural solar battery cells 10 (6 in length x 4 in width = 24), in a rectangular state by means of not-shown joint members, which are structured with solar batteries covered with square transparent plates 9.

A solar battery can be of an energy converter using P-N junction, that is, in which a 1-3µ P-type layer on N-type Si board is provided, so that a so-called photo electromotive force effect is made of use the sun light which falls into the P-N junction from surface thereof.

The modules 3 are arranged in a frame 11 to be nearly the same with dimensions of the base panel 2.

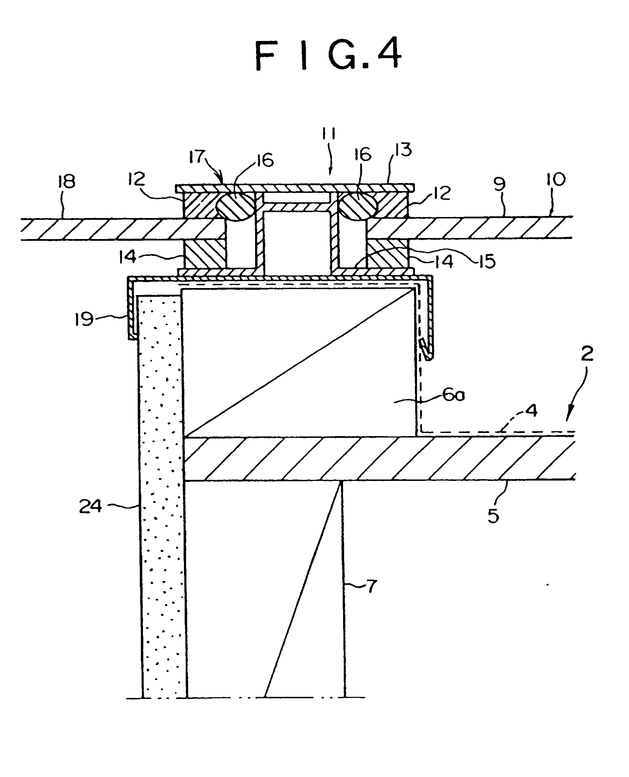

A frame 11 is as shown in Fig. 4 that frame members 17 are assembled in a lattice condition in accordance with the shape of the previous blocks, the frame member 17 consisting of flat upper plates 13, at both lower transverse end portions thereof, attached with sealing members 12, a lower plate 15 formed into a convex shape and attached with sealing members 14 at both upper transverse end portions, and packing 16 held between the below of the upper plates 13 and the upper end of the lower plates 15.

And after the lower plates 15 are secured on the longitudinal cores 6a or transverse cores 6b by nailing and so on, respective edges of the module 3 (a transparent plate 9 of the module 3) are held between the sealing members 12 and 14, and the upper plate 13 is connected with the lower plate 15 by screw fastening and so on, whereat edges of each module 3 set and fix into a C-shaped portions formed by the upper plate 13 and lower plate 15.

As described above, the respective modules 3 are attached at the frame 11 in which the frame member 17 is located on the longitudinal cores 6a and transverse cores 6b of the aforedescribed base panel 2 by bonding agent whereat the roof panel 1 is composed by the plural modules 3.

By the way, the roof panel 1 includes therein an air ventilation layer 1A, between the plywood 5 and the modules 3, which is extending from the eaves P to a ridge Q as the transverse cores 6b are isolated away from the plywood 5 as described above. In addition, the longitudinal cores 6a are provided with a cut-out portion (not-shown) passing through next air ventilation layer 1A of a neighbor block.

As to the eaves P, like showing in Fig. 5, the longitudinal core 6a reaches the end of the eaves P and from the most end of the modules 3 of the eaves P to the end of the eaves P, there is provided a fixed space into which a heat insulating board 47 is fitted on the longitudinal core 6a entirely at the eaves area.

An upper eaves cutwater 48 is attached on a heat insulating board 47. And a lower eaves cutwater 49 is attached on the pointed end of a base panel 2.

And yet, the aforedescribed surface of the upper eaves cutwater 48 is painted color of white to hardly absorb temperature.

Next, the aforedescribed skylight sash portion 8 is explained that a block whereat the skylight sash portion 8 of the base panel 2 is cut open, and the abovedescribed longitudinal core 6a and the transverse core 6B that is the same thickness with the longitudinal core 6a are secured on the upper surface edge of the plywood 5 around the opening 2A and the abovedescribed common rafter 7 is secured under the lower surface of the plywood 5.

As shown, between the frame members 17 corresponding to the skylight sash portion 8 of the frame 11, a glass 18 is fitted. The glass 18 is rectangular having the same dimensions as such module 3, and it is, as the module 3, fitted between the frame members 17.

The previous asphalt roofing 4 covers over the previous longitudinal core 6a and transverse core 6B provided around the skylight sash portion 8 and on the asphalt roofing 4, a cutwater 19 formed into C-shape is inlaid and fixed. The cutwater 19 is secured on the longitudinal core 6a and transverse core 6B along with the lower plate 15 of the previous frame 11.

On the other hand, as depicted in Figs. 2 and 3, a ceiling 20 below the roof is structured with the ceiling joists 21 and the ceiling boards 22 which is made of a plaster board and so on and is secured on the joists 21. A portion applied for such skylight sash portion 8 is cut out by cutting process and so on as to be an opening 20A. Incidentally, at an upper portion of a ceiling board 19, the beams 23 are provided.

And, the roof panel 1 is located such that the skylight sash portion 8 thereof meets with the openings 20A of the ceiling 20 and is mounted on the ceiling 20 as the common rafters 7 contact with the upper beams 23 to be securely connected to each other by means of bonding agent, nailing or the like.

Therefore, from within the house such as living rooms below the ceiling 20, outside view can be seen through the glass 18, and the sunbeam streams into the house.

Now referring to the roof panel 1 of the above explained embodiment, the number of modules 3 for the single roof panel 1 totals up to 7, but in a practical use, it can be determined upon, in consideration of the voltage obtained by single module 3, the voltage required in the house.

Therefore, the modules 3 are spread in number to obtain required voltage by the roof panel 1. And the modules 3 are electrically connected in series bv wired electrical wire in the air ventilation layer 1A as plotted by a dotted line 27 in Fig. 1 and are also electrically connected with charging means (not-shown) in a general house J from the inside of ridge metal fittings 26, so that the electric power supply in the house can be supplied from the charging means.

In the above structured roof Y, an open-air wind flows into a ridge ventilation metal fittings 26 from the ventilator of the ventilation louver 25 at the eaves P by way of the air ventilation layer 1A in the roof panel 1 to thereby flow out the inlet air.

Hence, the flowing wind effects heat radiation from the back of solar battery modules 3, and rising temperature of the solar battery modules 3 is well suppressed, consequently, energy conversion efficiency of the solar battery is always preserved very well.

Moreover, the air ventilation layer 1A extends along a slope to the ridge Q from the eaves P so that in the air ventilation layer 1A rising air flow that is to the ridge Q from the eaves P is produced, flowing of air in the air ventilation layer 1A is more active for the rising air flow, therefore, suppressed action of rising temperature in the modules 3 is promoted.

As a result, the energy conversion efficiency of the solar battery module 3 is always maintained high to obtain stable electrical power supply.

It should be understood that the ventilation louver 25 as an air intake to an air ventilation layer 1A regulates the inflow into the air ventilation layer 25 of such as rain-water or dust, and also acts as a spacer to maintain the regular intervals between the upper eaves cutwater 48 and the lower 49.

Incidentally, a surface of the eaves cutwater 48 forming a surface of the eaves P is painted with a color of white to disturb the heat absorption so as to prevent a temperature hike of the air flowing into the air ventilation layer 1A.

And because the heat insulating board 47 under the eaves cutwater 48 has the heat insulating effect, the inlet air into the air ventilation 1.

Still more, the number of module 3 provided on the roof panel 1 is decided upon the required voltage, so that an inconvenience to supply unnecessary high voltage or to supply insufficient voltage can be averted, to thereby supply only necessary voltage effectively.

Since the electrical wire 27 of each module 3 is wired in the air ventilation layer 1A, it is not influenced by the wind, rain, and the sun light directly.

Furthermore, as the air ventilation layer 1A passes through from the eaves P to the ridge Q, if the electrical wire 27 is wired as drawing out of the end of the ridge Q while the roof panel 1 is composed, whereby the work of the electric wiring for the solar battery on the roof will not be required at all and a time for the installation can be reduced.

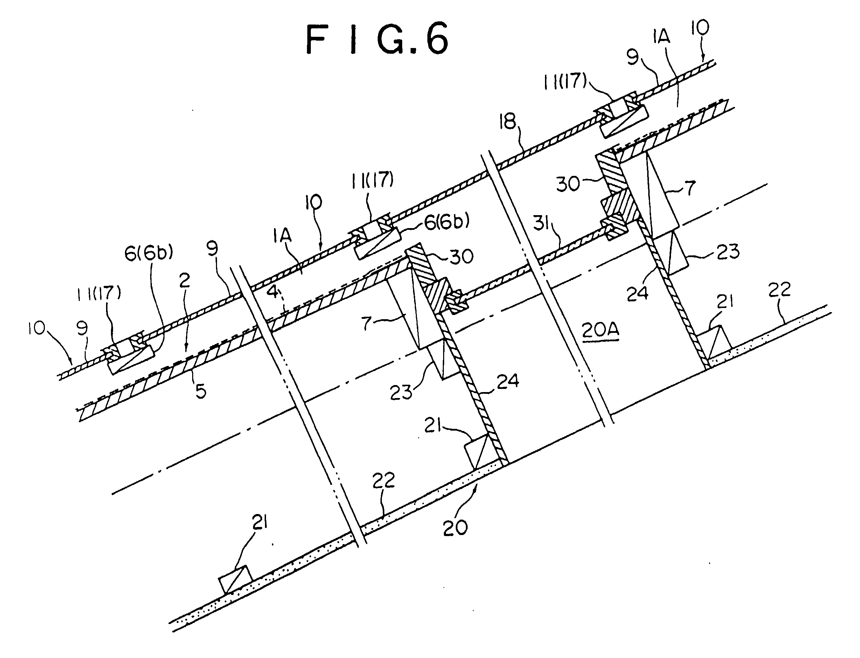

Fig. 6 depicts the second embodiment of the present invention.

The second embodiment is characterized to have a ceiling window inlaid with a transparent glass 31 through parting boards 30 and others over the opening 20A of the ceiling 20. The following other parts are constructed in the same way as the prescribed first embodiment. The same reference numerals will be used to designate the same part and each explanation will be omitted.

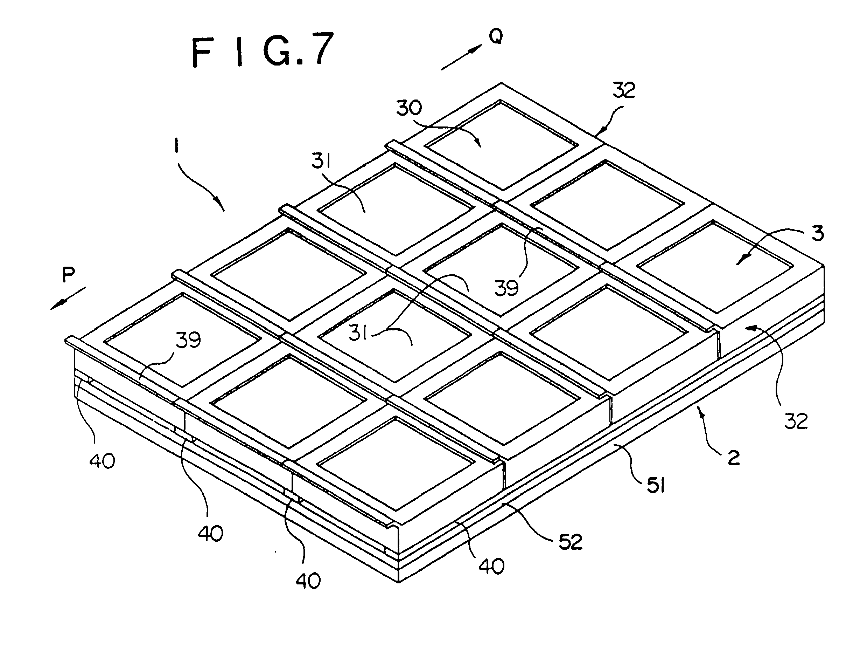

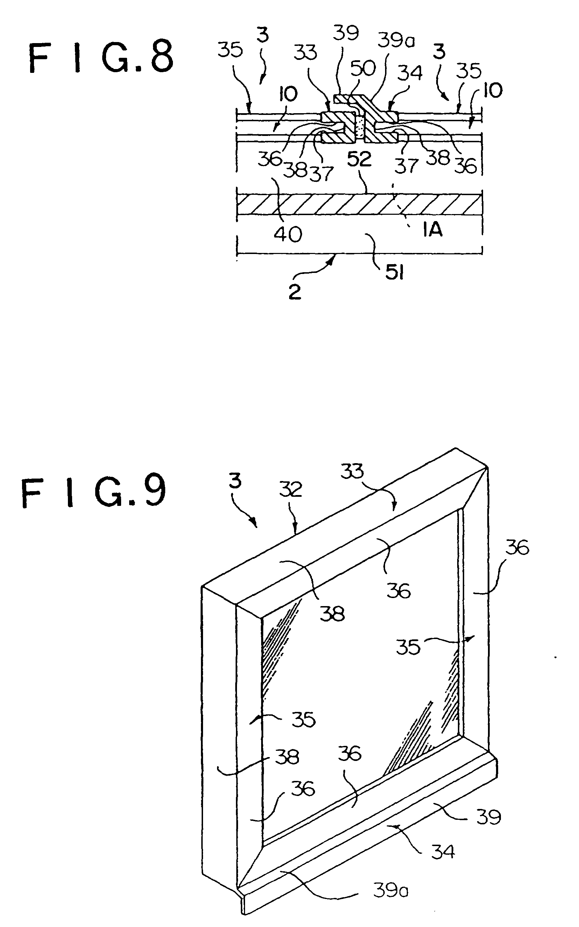

Fig. 7 and 9 depict the third embodiment of the present invention.

The above mentioned solar battery module 3 which is supported by the frame 11 corresponding to the entire roof panel 1 in the above explained first embodiment is supported with individual frame 32. The remainder is the same as those in the above explained first embodiment, so that the individual description is omitted by adding the same marks to the same parts.

In Fig. 7, the roof panel 1 is structured with plural solar battery panels 3 which are arranged on the base panel 2 so that the entire roof panel 1 becomes rectangular, and the longitudinal direction of the roof panel 1 aligns along the slant of the roof from the ridge Q to the eaves P.

The base panel 2, as depicted in Fig. 2, has a rectangular shape defined by the core 51 and the plate 52 which is secured on the core 51 by means of such as a bonding agent or nailing.

The solar battery panel 30 is composed with the solar battery module 3 of a rectangle panel in which a number of solar battery cells are installed in a transparent plate, and the frame 32 frame-structured on all sides of the module 3.

The frame 32 has 3 types which are a frame 35 and a frame 34 to be provided on each top and bottom side against solar battery module 3 and the frame 35 to be provided each on other pair of side.

The frames 33, 34 and 35 are basically the same structure that is a section of formed C with a upper plate 36, a lower plate 37 and a edge plate 38 to link each other and is made of aluminum extruded material and is utilized the four sides of the solar battery 31 in the ditch, and then the solar battery panel 30 shown in Fig.3 is assembled. The upper plate 36 in the frame 34 of the frame 33,34 and 35, in way of a slant portion 39a connected to the upper plate 36, a elongated fragment 39 extended to the outside is formed.

The solar battery panels 30 are arranged on the base panel 2 in a state that the upper frame 33 is facing toward the ridge Q, the lower frame 34 toward the eaves P and the longitudinal frame 35 along the sloping line from the ridge Q to the eaves P.

On the base panel 2, a supporting member 40 (corresponding to the longitudinal core 6a in the previous first embodiment) is attached firmly and the solar battery panel 30 is fitted on the base panel 2 by way of attaching the supporting member 40 to both sides of the longitudinal frame 35. A sealing member 50 is inlaid into the space among the solar battery panels 30 on a same plane.

In such installed state, the extending piece 39 formed at the lower frame 34 of the solar battery panel 30 located on the ridge Q is parallel to the upper plate 36 of the upper frame 33 of the next solar battery panel 30 on the eaves P and covers a part of the upper plate 36.

A space in which the extending piece 39 of the lower frame 34 overlaps the upper plates 36 of the upper frame 33 is provided to prevent the rainwater from going up and infiltrating into among the solar battery modules 3 by the capillary phenomenon used in the slant roof.

A space is opened between the base panel 2 and the solar battery panel 30 by the supporting member 40 and the space should be considered as an air ventilation layer 1A from the eaves P to the ridge Q.

The air ventilation layer 1A is opened toward the outside of the eaves P and the ridge Q in the same construction of the previous first embodiment. The explanations of remaining structures will be omitted since they have the same or similar ones.

Now, the roof panel 1 in the third embodiment is defined as a house roof by being fixed on such as the beam with the solar battery panel 30 turning up and the upper frame 33 turning to the ridge Q.

When rain-water flows from the solar battery panel 30 of the ridge Q to the solar battery panel 30 of the eaves P on the roof panel 1, the rain-water passes guided by an elongated fragment 39 formed on the lower frame 34 onto the solar battery panel 30 of the eaves P.

Accordingly, it is hard for the rain-water to seep into the space among the solar battery panels 30 arranged along the slope of the roof. Even if the rain-water happens to seep into the crevice between the elongated fragment 39 and the upper frame 33, the sealing member 50 prevents the rain-water from seeping.

In addition, the ventilation layer 1A extending from the eaves P to the ridge Q and provided between the base panel 2 and the solar battery panel 30 takes advantage that the heat is diffused from the solar battery module 3, an energy conversion efficiency is always maintained high, and the stable electric power is supplied as in the first embodiment.

Furthermore, the frame 11 composed of long members like in the previous first embodiment will not be needed to use by way of using the frame 32 of each module 3 to simplify handling thereof, and it will not be required to prepare different frames 11 depending on the width and length of the roof panel 1.

Accordingly, the installation and handling can be simplified by using the mentioned solar battery panel 30 consisting of the module 3 and the frame 32.

### INDUSTRIAL AVAILABILITY

As described in the above, according to the present invention, an action of heat radiation is developed because air passes through the air ventilation layer formed between the base panel and solar battery module, by which an energy conversion efficiency of the solar battery is always maintained effectively and a stable electrical power supply is improved.

A heat transmission to the air going into the air ventilation layer can be reduced and a control effect of temperature rise of the air passing through the air ventilation layer can be developed by providing the thermal insulation material under the board of the previous eaves.

Furthermore, the temperature rise of the air going into the air ventilation layer from the eaves can be reduced and the cooling effect of the solar battery can be developed more by painting the surface of the eaves board white preventing the heat from being absorbed.

As the eaves is prepared with upper and lower eaves cutwater to communicate the air ventilation layer with the fresh air and with the ventilation louver between such cutwaters, rain-water, dust and others can be prevented from penetrating into the air ventilation layer and the intervals between the cutwaters can be maintained evenly.

Sufficient electric power can be supplied effectively by providing the necessary number of solar battery modules supplying the necessary electric power for installation.

In a case that the solar battery panel consists of the solar battery module and the elongated frame extended from the eaves side thereof, the eaves side frame of the solar battery panel located at ridge side is provided with the elongated fragment extending over the ridge side frame of the corresponding solar battery panel located at the eaves side to prevent rain-water from seeping into between the solar battery panels laid along the slope of the roof and the dead water can be improved. The solar batter panel located in the ridge side to the ridge side of the solar battery panel located in the eaves side is arranged, so that the rain-water is prevented from seeping into between the solar battery panels laid along the slope of the roof. In addition, the dead water can be improved more when the sealing member is applied between the both solar battery panels.

## Claims

1. A roof with at least one solar battery (Y) the roof comprising:
a base panel (2) extending along from the ridge portion (Q) to the eaves portion (P) of a tilted roof of a house;
at least one solar battery panel (10) arranged along the upper surface of said base panel;
a frame (11) receiving said at least one solar battery panel;
a supporting member (6) supporting said frame on said base panel in use;
a ventilation layer (1A) provided between said solar battery panel and said base panel, the ventilation layer extending from the eaves portion to the ridge portion,
**characterised by**:
an upper eaves cutwater member (48) provided at the eaves portion; and
a lower eaves cutwater member (49) provided under the eaves portion which is substantially parallel to the upper eaves cutwater member;
wherein the space between the eaves cutwater members communicates with said ventilation layer in use and is provided with a ventilation louver (25).

2. A roof with at least one solar battery (Y) according to claim 1, wherein said ventilation layer (1A) is opened at the eaves portion (P) and the ridge portion (Q).

3. A roof with at least one solar battery (Y) according to claim 1, wherein said supporting member (6) extends to the eaves portion and has thereon and thereunder the eaves cutwater.

4. A roof with a solar battery (Y) according to claim 1, further comprising a heat insulation member (47) positioned between the supporting member (6) and the upper eaves cutwater (48).

5. A roof with a solar battery (Y) according to claim 1,
wherein the upper eaves cutwater member (48) has a white surface.

6. A roof with a solar battery (Y) according to claim 1,
wherein the frame (11) is structured so that it surrounds the solar battery (10) and has C-shaped portions to engage with peripheral portions of the at least one solar battery panel wherein the at least one solar battery panel is held at the C-shaped portions through a seal member.

7. A roof with a solar battery (Y) according to claim 1,
wherein the at least one solar battery panel (10) is square.

8. A roof with a solar battery (Y) according to claim 1, further comprising an extended piece (39) on the side of the frame (11) towards the eaves portion (P), the extended piece being shaped so as to overlap the side towards the ridge portion of an adjacent frame in use.

9. A roof with a solar battery (Y) according to claim 7,
wherein the extended piece (39) has a tapered portion extending from the upper surface of the frame (11) and a flattened portion which, in use, can overlap with an adjacent frame.

## Patentansprüche

1. Dach mit zumindest einer Solarbatterie (Y), wobei das Dach umfasst:
eine Grundplatte (2), die sich längs des Firstbereichs (Q) hin zum Traufbereich (P) eines geneigten Daches eines Hauses erstreckt;
zumindest eine Solarbatterienplatte (10), die angeordnet ist längs der oberen Oberfläche der Grundplatte (2);
einen Rahmen (11), der zumindest eine Solarbatterienplatte aufnimmt;
ein Stützelement (6), welches den Rahmen auf der sich in Verwendung befindlichen Grundplatte stützt;
eine Belüftungsschicht (1A), die angebracht ist zwischen der Solarbatterienplatte und der Grundplatte, wobei die Belüftungsschicht sich vom Traufbereich zum Firstbereich erstreckt, **dadurch gekennzeichnet, dass**:
ein oberes Traufwellenbrecherelement (48) angebracht ist am Traufbereich;
ein unteres Traufwellenbrecherelement (49) angebracht ist unter dem Traufbereich, welcher im Wesentlichen parallel ist zum oberen Traufwellenbrecherelement;
wobei der Raum zwischen den Traufwellenbrecherelementen in Verbindung steht mit der Belüftungsschicht, die sich in Verwendung befindet, und mit einem Lüftungsschlitz (25) versehen ist.

2. Dach mit zumindest einer Solarbatterie (Y) gemäß Anspruch 1, wobei die Belüftungsschicht (1a) am Traufbereich (P) und Firstbereich (Q) geöffnet ist.

3. Dach mit zumindest einer Solarbatterie (Y) gemäß Anspruch 1, wobei das Stützelement (6) sich vom Traufbereich wegerstreckt und oberhalb und unterhalb hiervon Traufwellenbrecherelemente enthält.

4. Dach mit einer Solarbatterie (Y) gemäß Anspruch 1, welches weiterhin umfasst ein Wärmeisolationselement (47), welches positioniert ist zwischen dem Stützelement (6) und dem oberen Traufwellenbrecher (48).

5. Dach mit einer Solarbatterie (Y) gemäß Anspruch 1, wobei das obere Traufwellenbrecherelement (48) eine weiße Oberfläche aufweist.

6. Dach mit einer Solarbatterie (Y) gemäß Anspruch 1, wobei der Rahmen (11) so ausgeführt ist, dass er die Solarbatterie (10) umgibt und C-förmige Bereiche aufweist um in Umfangsbereiche von der zumindest einen Solarbatterienplatte einzugreifen, wobei die zumindest eine Solarbatterienplatte an den C-förmigen Bereichen mittels eines Dichtungselements gehalten wird.

7. Dach mit einer Solarbattiere (Y) gemäß Anspruch 1, wobei die zumindest eine Solarbatterienplatte (10) quadratisch ist.

8. Dach mit einer Solarbatterie (Y) gemäß Anspruch 1, welches weiterhin ein sich erstreckendes Stück (39) auf der Seite des Rahmens (11) enthält, welches sich zum Traufbereich (P) hin erstreckt, wobei das sich erstreckende Stück so ausgeformt ist, dass es die Seite hin zum Firstbereich eines sich in Verwendung befindenden angrenzenden Rahmens überlappt.

9. Dach mit einer Solarbatterie (Y) gemäß Anspruch 7, wobei das sich erstreckende Stück (39) einen keilförmig zulaufenden Bereich hat, welcher sich von der oberen Oberfläche des Rahmens (11) erstreckt und einen abgeflachten Bereich aufweist, welcher in Verwendung mit einem angrenzenden Rahmen überlappen kann.

## Revendications

1. Toit avec au moins une batterie solaire (Y), le toit comprenant :
un panneau de base (2) s'étendant de la partie faîte (Q) à la partie gouttière (P) d'un toit de tuiles d'une maison ;
au moins un panneau à batterie solaire (10) disposé le long de la face supérieure dudit panneau de base ;
un châssis (11) recevant ledit au moins un panneau à batterie solaire ;
un élément de support (6) supportant ledit châssis sur ledit panneau de base lors de l'utilisation ;
une couche de ventilation (1A) placée entre ledit panneau à batterie solaire et ledit panneau de base, la couche de ventilation s'étendant de la partie gouttière à la partie faîte,
**caractérisé par** :
un élément déflecteur d'eau de gouttière supérieur (48) placé au niveau de la partie gouttière ; et
un élément déflecteur d'eau de gouttière inférieur (49) placé sous la partie gouttière qui est sensiblement parallèle à l'élément déflecteur d'eau de gouttière supérieur ;
l'espace entre les éléments déflecteurs d'eau de gouttière communicant avec ladite couche de ventilation lors de l'utilisation et étant doté d'un volet de ventilation (25).

2. Toit avec au moins une batterie solaire (Y) selon la revendication 1, dans lequel ladite couche de ventilation (1A) est ouverte au niveau de la partie gouttière (P) et de la partie faîte (Q).

3. Toit avec au moins une batterie solaire (Y) selon la revendication 1, dans lequel ledit élément de support (6) s'étend jusqu'à la partie gouttière et possède au-dessus et au-dessous de lui le déflecteur d'eau de gouttière.

4. Toit avec une batterie solaire (Y) selon la revendication 1, comprenant en outre un élément d'isolation thermique (47) positionné entre l'élément de support (6) et le déflecteur d'eau de gouttière supérieur (48).

5. Toit avec une batterie solaire (Y) selon la revendication 1, dans lequel le déflecteur d'eau de gouttière supérieur (48) a une surface blanche.

6. Toit avec une batterie solaire (Y) selon la revendication 1, dans lequel le châssis est structuré de telle sorte qu'il entoure la batterie solaire (10) et a des parties en forme de C pour entrer en prise avec des parties périphériques de l'au moins un panneau à batterie solaire, l'au moins un panneau à batterie solaire étant maintenu dans les parties en forme de C par un élément d'étanchéité.

7. Toit avec une batterie solaire (Y) selon la revendication 1, dans lequel l'au moins un panneau à batterie solaire (10) est carré.

8. Toit avec une batterie solaire (Y) selon la revendication 1, comprenant en outre une pièce allongée (39) sur le côté du châssis (11) orienté vers la partie gouttière (P), la pièce allongée étant configurée de manière à recouvrir lors de l'utilisation le côté orienté vers la partie faîte d'un châssis adjacent.

9. Toit avec une batterie solaire (Y) selon la revendication 7, dans lequel la pièce allongée (39) a une partie amincie s'étendant à partir de la surface supérieure du châssis (11) et une partie plane qui, lors de l'utilisation, peut se recouvrir avec un châssis adjacent.
